# FASCICULE DE BREVET EUROPEEN

(11) **EP 2 559 051 B1**
(45) Date de publication et mention de la délivrance du brevet: **19.07.2017**
(21) Numéro de dépôt: 11714038.4
(22) Date de dépôt: 13.04.2011
(51) Int. Cl.: H01J 37/317, G03F 7/20

(54) **PROCEDE DE LITHOGRAPHIE ELECTRONIQUE AVEC CORRECTION DES ARRONDISSEMENTS DE COINS**
VERFAHREN FÜR ELEKTRONENSTRAHLLITHOGRAFIE MIT ECKENRUNDUNGSKORREKTUR
METHOD OF ELECTRON-BEAM LITHOGRAPHY WITH CORRECTION OF CORNER ROUNDINGS

(30) Priorité: 15.04.2010 FR 1052869
(43) Date de publication de la demande: 20.02.2013
(73) Titulaire: Commissariat à l'Énergie Atomique et aux Énergies Alternatives, 75015 Paris (FR)
(72) Inventeur: MANAKLI, Serdar, F-38300 Meyrie (FR)
(74) Mandataire: Nguyen Van Yen, Christian
(86) Numéro de dépôt international: PCT/EP2011/055746
(87) Numéro de publication internationale: WO 2011/128348

(56) Documents cités:
- JP-A- S55 162 228
- US-A- 6 087 046
- US-A1- 2003 203 287
- US-A1- 2006 001 688
- US-A1- 2010 058 282

## Description

La présente invention s'applique au domaine de la lithographie électronique. Pour permettre la gravure de motifs dont la dimension critique est inférieure à 50nm, il faut intégrer dans les procédés de photolithographie optique des méthodes de correction des distorsions optiques de plus en plus complexes à la fois au stade de la conception et de la production des masques et au stade de l'exposition. Les coûts des équipements et des développements pour une nouvelle génération de technologie augmentent en conséquence dans des proportions très élevées. Aujourd'hui, les dimensions critiques accessibles en photolithographie sont supérieures ou égales à 65 nm. La génération 32-45 nm est en cours de développement et il n'existe pas de solution viable envisagée pour les noeuds technologiques inférieurs à 22 nm.

De son côté, la lithographie électronique permet dores et déjà la gravure de motifs de 22 nm ; elle ne nécessite pas de masque et offre un temps de développement assez court, ce qui permet une meilleure réactivité et flexibilité dans la réalisation d'améliorations aux technologies et aux designs. En revanche, les temps de production sont structurellement sensiblement plus élevés qu'en photolithographie puisqu'il faut réaliser une exposition pas à pas, alors que la photolithographie ne nécessite qu'une exposition par couche.

Le ou les faisceaux d'électrons utilisés pour effectuer la gravure d'un motif diffusent notamment sur courte distance (forward scattering ou blur) dans la résine et le substrat sur les bords du centre du faisceau, ce qui accroit la taille du faisceau et en réduit le contraste. De plus, les électrons sont complètement rétrodiffusés sur une longue distance (backward scattering).

Cet effet de proximité est particulièrement sensible aux angles des motifs à graver ou coins qui sont arrondis. Cet effet réduit la précision de la gravure, affecte la fonctionnalité des composants et est susceptible de diminuer les rendements de production des circuits intégrés.

Un certain nombre de procédés de l'art antérieur, dans les domaines de la photolithographie et de la lithographie électronique ont tenté d'apporter des corrections à ce phénomène d'arrondissement de coins. C'est notamment le cas en photolithographie des procédés prévoyant la modification des motifs à graver, notamment par extension de leur surface en fin de ligne, tel que ceux divulgués par K. Tsudaka et alii, Japanese Journal of Applied Physics, Vol. 36 (1997), pp. 7477-7481, K. Kim et alii, Japanese Journal of Applied Physics, Vol. 37 (1998), pp. 6681-6685 ainsi que par le brevet US 7,494,751.

En lithographie électronique, des procédés ont pour but de réduire de manière globale les effets de proximité, sans adresser le problème spécifique de l'arrondissement des coins des motifs à graver. C'est notamment le cas de la méthode décrite dans le brevet US 6,107,207, qui réalise une correction des effets de proximité en augmentant les doses de rayonnement en bord de motif. Cette augmentation de dose se traduit par une nouvelle augmentation des temps d'exposition, ce qui constitue un handicap très important pour la diffusion industrielle de cette technologie. Le document US2010/058282 décrit une façon de réduire les effets de proximité. Le document JPS55162228 décrit une façon de réduire l'arrondissement des coins entre des motifs perpendiculaires contigus. La présente invention a pour objectif et pour résultat de résoudre le problème posé par l'arrondissement des coins des motifs de manière adaptée aux procédés de lithographie électronique, notamment pour des technologies de l'ordre de 22 nm, sans impliquer d'augmentation significative des doses rayonnées.

A cet effet, l'invention prévoit un procédé de lithographie électronique selon la revendication 1. Avantageusement, la dimension critique du réseau de motifs est de l'ordre de 35 nm et ladite zone de non exposition de la résine produit un espacement entre lesdits deux motifs contigus de l'ordre de 10 nm.

Avantageusement, ledit motif de correction détermine une zone d'exposition de la résine ajoutée de manière contigüe à l'un au moins desdits deux motifs contigus.

Avantageusement, la dimension critique du réseau de motifs est de l'ordre de 35 nm, et ladite zone d'exposition de la résine produit un allongement dudit au moins un des deux motifs contigus dans sa plus grande dimension de l'ordre de 5 nm.

Avantageusement, lesdits motifs de correction, leurs dimensions et leurs emplacements sont déterminés par un modèle de détermination automatique d'un design cible comprenant les motifs contigus et les motifs de correction.

Avantageusement, le procédé de l'invention comprend en outre au moins une étape de calcul d'au moins une dimension d'au moins un des motifs contigus et une étape de calcul de modulation de doses sur lesdits motifs, lesdits calculs étant liés par une relation fonctionnelle faisant intervenir la latitude en énergie du procédé ou la position des bords des motifs.

Avantageusement, l'étape de combinaison dudit motif de correction avec lesdits motifs contigus utilise une fonction de rescaling négatif de la zone de non exposition.

Avantageusement, l'étape de génération d'au moins un motif de correction utilise une fonction eRIF.

Pour mettre en oeuvre le procédé, l'invention prévoit également un programme d'ordinateur selon la revendication 9. Avantageusement, le programme de l'invention comprend en outre un module d'application d'un modèle de détermination automatique d'un design cible comprenant les motifs contigus et les motifs de correction dont les dimensions et les emplacements sont déterminés par ledit modèle.

Avantageusement, le programme de l'invention comprend en outre au moins un module de calcul d'au moins une dimension d'au moins un des motifs contigus et un module de calcul de modulation de doses sur lesdits motifs, lesdits calculs étant liés par une relation fonctionnelle faisant intervenir la latitude en énergie du procédé.

Dans un mode de réalisation particulièrement avantageux, l'invention est combinée avec un mode spécifique de modulation des doses rayonnées couplée avec un resizing des motifs en optimisant la latitude en énergie du procédé, ce qui permet de limiter les pertes de linéarité pour les procédés de technologie de dimension critique inférieure à 70 nm, de limiter également l'augmentation de l'IDB (Isolated Dense Bias ie différence entre les dimensions critiques pour des structures isolées et denses), de limiter l'augmentation du raccourcissement des fins de ligne (Line End Shortening ou « LES »), et de limiter la réduction de la latitude en énergie («Energy Latitude ou « EL »), tous effets qui se produisent lorsque ces méthodes de modulation de dose de l'art antérieur sont appliquées. Ces défauts des méthodes de correction des effets de proximité telles que celles décrites dans le brevet US 6,107,207 ont été exposés notamment dans la publication de S. Manakli, « New Electron Beam Proximity Effect Correction Approach for 45 and 32 nm Nodes », Japanese Journal of Applied Physics, Vol. 45, N°8A, pp. 6462-6467.

En outre, compte tenu des modalités de calcul des corrections, une automatisation des calculs de correction de manière intégrée aux outils de conception assistée par ordinateur est réalisable, ce qui procure l'avantage inestimable d'offrir aux utilisateurs du système et du procédé selon l'invention une conversion de leurs bibliothèques de composants standard à coût réduit.

L'invention sera mieux comprise, ses différentes caractéristiques et avantages ressortiront de la description qui suit de plusieurs exemples de réalisation et de ses figures annexées dont :
- La figure 1 illustre l'effet d'arrondissement de coins des motifs à graver sans application du procédé de correction de l'invention ;
- La figure 2 représente une vue d'un motif à reproduire et d'un motif reproduit, sans correction des arrondissements de coins et avec correction des arrondissements de coins dans un procédé de photolithographie de l'art antérieur;
- Les figures 3a, 3b, 3c et 3d représentent respectivement de manière schématique un motif à coins à graver, l'application de doses rayonnées sans corrections, le résultat de ladite application sans correction et le résultat de l'application de corrections dans un mode de réalisation de l'invention ;
- La figure 4 représente l'ordinogramme d'un procédé de correction des arrondissements de coins dans un mode de réalisation de l'invention ;
- Les figures 5a, 5b et 5c représentent respectivement un motif à coins à graver, l'application d'une correction de l'arrondissement d'un coin intérieur et l'effet de l'application de cette correction dans un mode de réalisation de l'invention;
- Les figures 6a, 6b et 6c représentent respectivement un motif à coins à graver, l'application d'une correction de l'arrondissement d'un coin extérieur et l'effet de l'application de cette correction dans un exemple ne faisant pas partie de l'invention;
- La figure 7 illustre le procédé de resizing des bords du bloc à graver selon une variante de l'invention ;
- Les figures 8a, 8b, 8c, 8d et 8e illustrent l'application d'une technique d'extrusion utilisant une fonction de rescaling négatif dans un mode de réalisation de l'invention;
- Les figures 9a et 9b illustrent l'application d'une technique de génération des motifs de correction utilisant une fonction eRIF dans un mode de réalisation de l'invention;
- Les figures 10a, 10b, 10c et 10d illustrent un exemple de réalisation de l'invention d'une technique d'extrusion d'un motif de correction par comparaison avec une réalisation de l'exposition sans extrusion, pour un premier type particulier de motif à graver ;
- Les figures 11a, 11b, 11c et 11d illustrent un exemple de réalisation de l'invention d'une technique d'extrusion d'un motif de correction par comparaison avec une réalisation de l'exposition sans extrusion, pour un deuxième type particulier de motif à graver ;
- Les figures 12a, 12b, 12c et 12d illustrent un exemple de réalisation de l'invention d'une technique d'extrusion d'un motif de correction par comparaison avec une réalisation de l'exposition sans extrusion, pour un troisième type particulier de motif à graver ;
- Les figures 13a, 13b, 13c et 13d illustrent un exemple de réalisation de l'invention d'une technique d'extrusion d'un motif de correction par comparaison avec une réalisation de l'exposition sans extrusion, pour un quatrième type particulier de motif à graver ;
- Les figures 14a, 14b, 14c et 14d illustrent un exemple de réalisation de l'invention d'une technique d'extrusion d'un motif de correction par comparaison avec une réalisation de l'exposition sans extrusion, pour un cinquième type particulier de motif à graver ;
- Les figures 15a, 15b, 15c et 15d illustrent un exemple de réalisation de l'invention d'une technique d'extrusion d'un motif de correction par comparaison avec une réalisation de l'exposition sans extrusion, pour un sixième type particulier de motif à graver ;
- Les figures 16a, 16b, 16c et 16d illustrent un exemple de réalisation de l'invention d'une technique d'extrusion d'un motif de correction par comparaison avec une réalisation de l'exposition sans extrusion, pour un septième type particulier de motif à graver.

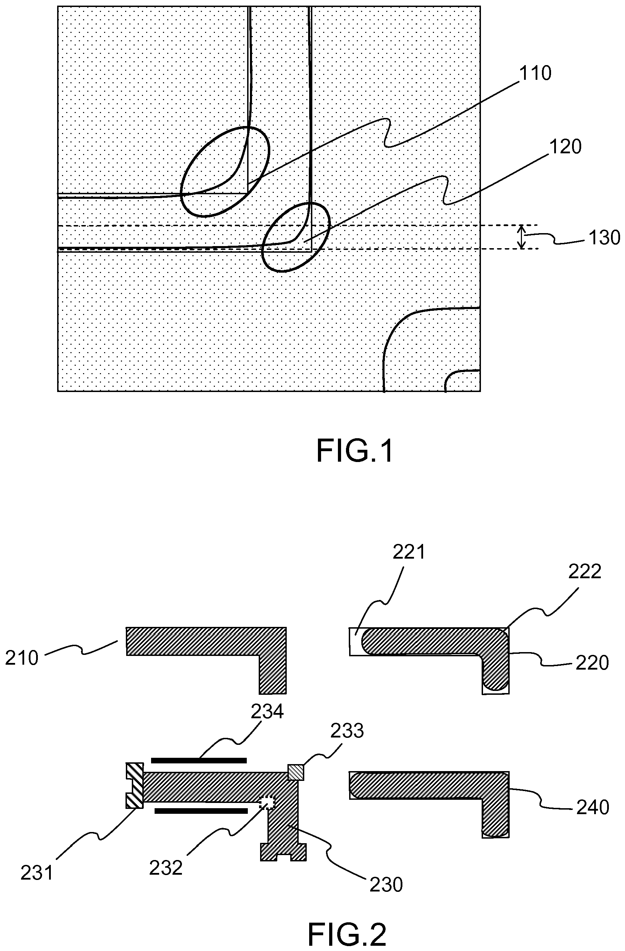

La figure 1 illustre l'effet d'arrondissement de coins des motifs à graver sans application du procédé de correction de l'invention.
Il s'agit d'une vue d'une gravure effectuée par un procédé de lithographie électronique utilisant un procédé de modulation de dose de l'art antérieur.
Comme on le voit sur la figure, les deux coins 110, 120 sont arrondis de manière assez significative puisque le rayon de courbure de l'arrondissement, 130, est approximativement égal à une demi-largeur de motif.
On désignera dans la suite l'arrondissement des coins ou Corner Rounding, par les initiales CR. On distinguera le Inner CR ou ICR, 110, ou arrondissement du coin intérieur, et le Outer CR ou OCR, 120, ou arrondissement du coin extérieur.
La modulation de doses peut être combinée avec l'inclusion de motifs sérigraphiques comme dans un procédé de photolithographie, tel qu'illustré sur la figure 2. Les procédés de ce type présentent notamment l'inconvénient de ne pas permettre une correction complète des arrondissements, en particulier à l'intérieur du L du motif à graver (ICR, 110), car le procédé de correction par adjonction de motifs sérigraphiques est particulièrement difficile à maîtriser. En outre, la modulation de dose implique une augmentation importante du nombre de shots et des temps d'exposition. Or les ICR sont considérés comme particulièrement critiques par les règles de design de la plupart des procédés, notamment sur les couches actives. Il importe en particulier d'être en mesure de supprimer complètement les ICR au-dessus de 20 nm. Le procédé de l'invention permet de parvenir à ce résultat, comme illustré plus loin dans la description.

La figure 2 représente une vue d'un motif à reproduire et d'un motif reproduit, sans correction des arrondissements de coins et avec correction des arrondissements de coins dans un procédé de photolithographie de l'art antérieur.
Le motif 210 à reproduire est transféré dans la résine sous la forme d'une image déformée 220. En particulier, cette image comporte un raccourcissement de fin de ligne (LES), 221 et des arrondissements de coins (CR) tels que 222, du fait de l'effet de réduction de contraste aux extrémités du motif.
Le motif 230 à reproduire est modifié par adjonction de motifs sous-résolus tels qu'une « tête de marteau » ou « hammerhead », 231, un empattement ou « serif », 233, ou une ou plusieurs barres de diffusion ou « scattering bar », 234. Le motif peut également être une soustraction de matière telle qu'une « morsure de souris » ou « mousebite », 232. L'impact d'un rayon lumineux conformé de manière particulière (un seul faisceau central, faisceau dipolaire, faisceau quadripolaire ou faisceau annulaire) avec ces motifs sous-résolus crée un effet de diffraction qui rétablit le contraste et transfère le motif modifié par ces adjonctions et soustractions dans la résine avec une image, 240, identique au motif initial avant adjonctions/soustractions.

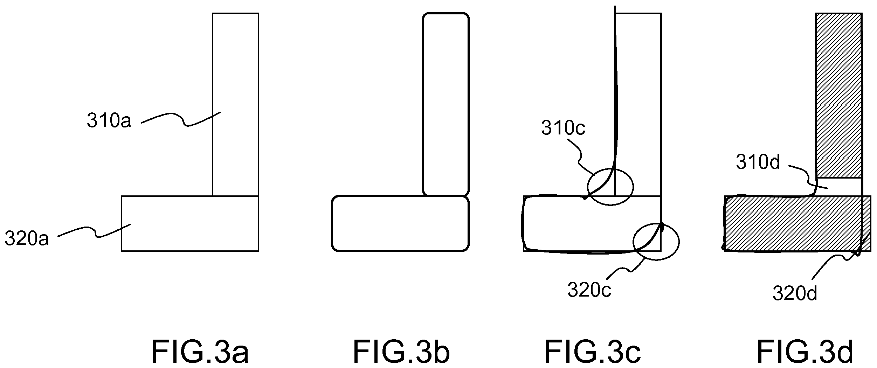

Les figures 3a, 3b, 3c et 3d représentent respectivement de manière schématique un motif à coins à graver, l'application de doses rayonnées sans corrections, le résultat de ladite application sans correction et le résultat de l'application de corrections dans un mode de réalisation de l'invention.
La figure 3a représente deux motifs contigus perpendiculaires, 310a et 320a, à reproduire.
La figure 3b représente les mêmes deux motifs contigus à reproduire sans correction spécifique.
La figure 3c représente la gravure des deux motifs contigus perpendiculaires sur le substrat résiné en utilisant un procédé de l'art antérieur. L'ICR, 310c, l'OCR, 320c, sont apparents sur la figure, de manière identique à la figure 1.
La figure 3d représente le résultat de l'application du procédé de l'invention pour graver le motif de la figure 3a, en appliquant des corrections dont les modalités seront explicitées plus loin dans la description. De manière synthétique, pour des motifs dont la dimension critique est de l'ordre de 35 nm, le procédé consiste, pour corriger l'ICR, à insérer une zone de non exposition ou ouverture, 310d, qui sépare les deux motifs contigus, 310a et 320a, d'une distance de l'ordre de 10 nm, et, pour corriger l'OCR, à allonger le motif 320a d'une zone d'exposition supplémentaire ou extension vers l'extérieur, 320d, d'une longueur selon la dimension la plus grande du motif 320a de l'ordre de 5 nm.
Les zones de non exposition et d'exposition supplémentaire, 310d et 320d, peuvent être insérées par application de règles programmées à cet effet. Les dites règles peuvent également être incluses dans un modèle de génération d'un design corrigé prenant en compte les motifs à graver ainsi que les zones correspondant à des motifs à soustraire ou ajouter pour réaliser les corrections nécessaires pour supprimer les CR.

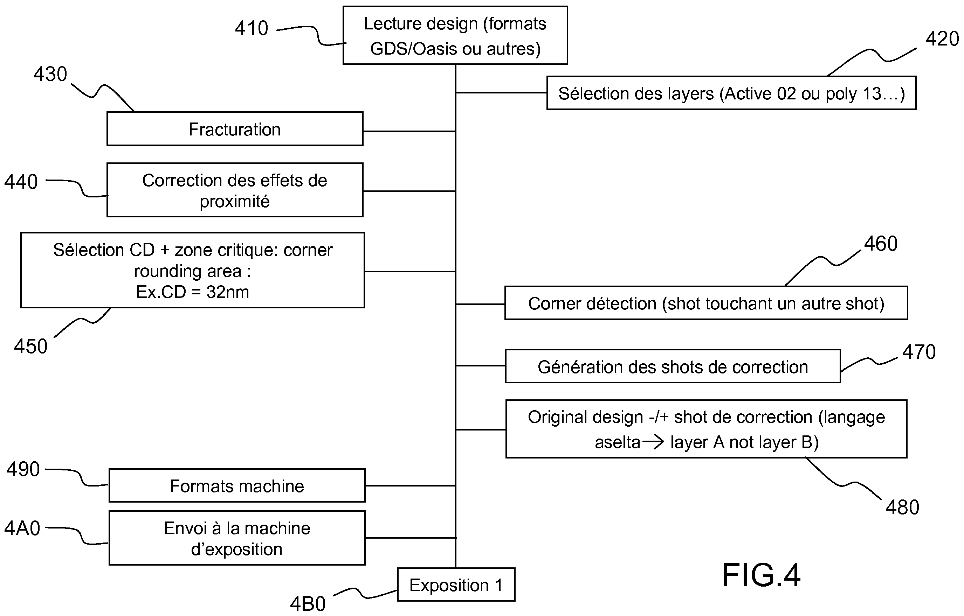

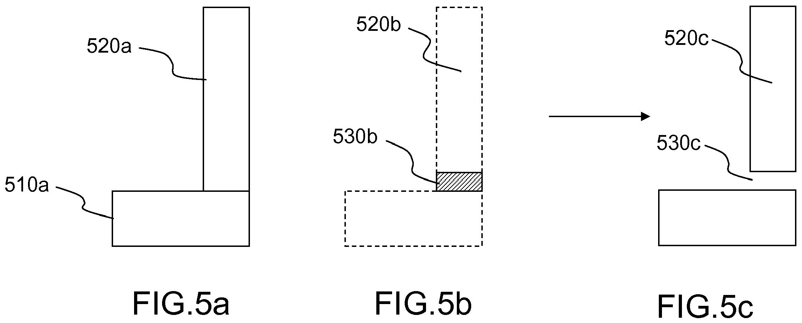

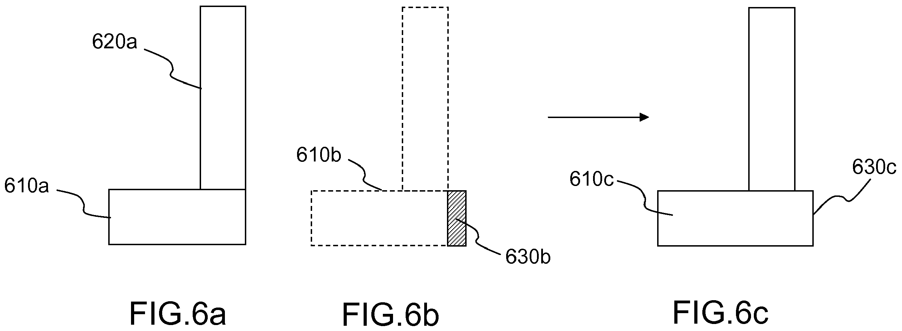

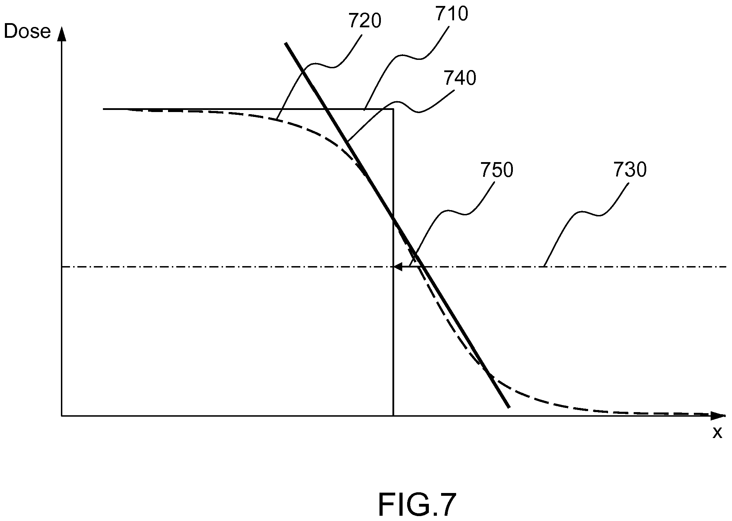

La figure 4 représente l'ordinogramme d'un procédé de correction des arrondissements de coins dans un mode de réalisation de l'invention.
De manière classique pour un homme de l'art, le procédé de l'invention commence par une étape, 410, de lecture du design. Le lay-out des motifs à graver est classiquement encodé dans des fichiers au format GDS Il (Graphie Data System version2) ou OASIS (Open Artwork System Interchange Standard). La machine et le logiciel utilisés sont par exemple une machine de marque VISTEC™ ou ADVANTEST™. Son logiciel de pilotage est adapté de manière à pouvoir mettre en oeuvre les différentes étapes décrites ci-dessus.
On sélectionne ensuite au cours d'une étape 420 les couches où les motifs doivent être gravés.
On réalise ensuite une étape de fracturation, 430, au cours de laquelle les motifs à graver sont répartis en zones qui seront exposées par un shot. Ledit shot aura une dose de rayonnement déterminée par le programme d'exposition.
Au cours d'une étape 440, on réalise une correction des effets de proximité, soit par modulation de dose, en fonction du positionnement du motif à graver par rapport aux bords du motif général, soit en appliquant une variante de l'invention qui comprend un resizing du motif, ladite variante étant explicitée plus loin dans la description en commentaire à la figure 7.
Au cours d'une étape 450, on identifie les zones critiques, c'est-à-dire celles comprenant des motifs à graver contigus perpendiculaires, susceptibles de générer des CR. Cette étape de sélection dépend de la dimension critique du procédé appliqué au réseau de motifs.
Au cours d'une étape 460, on détecte les CR dans les zones qui ont été identifiées au cours de l'étape précédente.
On génère ensuite, au cours d'une étape 470, les shots de correction selon des règles qui seront détaillées plus loin en commentaire aux figures 5 et 6. Cette étape de génération sera différente selon que l'on corrige un ICR ou un OCR. Dans le premier cas, on génère une zone de non exposition entre les deux motifs contigus perpendiculaires. Dans le deuxième cas, on génère une zone d'exposition qui allonge un des motifs contigus perpendiculaires à graver.

Au cours d'une étape 480, on réalise ensuite le design comprenant les motifs originaux et les motifs de correction.
Au cours d'étapes 490, 4A0 et 4B0, on finalise les commandes de la machine de lithographie électronique en convertissant les instructions générées au cours des étapes précédente en format machine, en les envoyant à ladite machine, puis en réalisant l'exposition.
Les figures 5a, 5b et 5c représentent respectivement un motif à coins à graver, l'application d'une correction de l'arrondissement d'un coin intérieur et l'effet de l'application de cette correction dans un mode de réalisation de l'invention.
La figure 5a représente deux motifs contigus perpendiculaires, 510a et 520a.
Dans un mode particulier de réalisation de l'invention, ces deux motifs ont une dimension critique de l'ordre de 35 nm.
La figure 5b représente les deux mêmes motifs contigus perpendiculaires, ainsi qu'un motif de correction de l'ICR attendu, 530b. Ledit motif de correction est destiné à ne pas être gravé et constitue donc une soustraction au motif à graver 520a pour réaliser ladite correction. Ce motif sera implanté entre les deux motifs contigus et aura la même largeur que ledit motif 520a, devenu 520b. Sa dimension dans la direction de la dimension la plus grande du motif 520a sera calculée à l'étape 470 du procédé illustré par la figure 4.
Cette dimension sera de l'ordre de 10 nm, dans l'exemple de réalisation où la dimension critique du motif 520a sera de l'ordre de 35 nm.
La figure 5c représente le résultat de la gravure du design comprenant les deux motifs originaux à graver, respectivement 510a, 520a, le deuxième devenant, après réalisation de la gravure, 520c, d'une longueur réduite sensiblement de la dimension du motif de correction, 530c.
Les figures 6a, 6b et 6c représentent respectivement un motif à coins à graver, l'application d'une correction de l'arrondissement d'un coin extérieur et l'effet de l'application de cette correction dans un exemple ne faisant pas partie de l'invention.
La figure 6a représente deux motifs contigus perpendiculaires, 610a et 620a. Dans un mode particulier de réalisation de l'invention, ces deux motifs ont une dimension critique de l'ordre de 35 nm.

La figure 6b représente les deux mêmes motifs contigus perpendiculaires, ainsi qu'un motif de correction de l'OCR attendu, 630b. Ledit motif de correction est destiné à être gravé et constitue donc une addition au motif à graver 610a pour réaliser ladite correction. Ce motif sera implanté pour réaliser un allongement d'un des deux motifs contigus (dans le cas représenté par la figure, du motif 610a) et aura la même largeur que ledit motif 610a, devenu 610b. Sa dimension dans la direction de la dimension la plus grande du motif 610a sera calculée à l'étape 470 du procédé illustré par la figure 4. Cette dimension sera de l'ordre de 5 nm, lorsque la dimension critique du motif 610a sera de l'ordre de 35 nm.
La figure 6c représente le résultat de la gravure du design comprenant les deux motifs originaux à graver, respectivement 610a, 620a, le premier devenant, après réalisation de la gravure, 610c, d'une longueur augmentée sensiblement de la dimension du motif de correction, 630c.

A titre de variante de réalisation, on peut effectuer, au cours d'une étape 440, un resizing du design cible en utilisant le procédé d'optimisation combinée de la géométrie du CIF et des lignes et de la modulation de dose rayonnée selon le procédé divulgué par la demande de brevet français déposée par la demanderesse de la présente demande sous le numéro FR1052862. Selon le procédé décrit par cette demande de brevet, qui vise une correction des effets de proximité inhérents aux procédés de lithographie pour les géométries inférieures à 50 nm, on calcule les doses à appliquer dans les shots correspondant aux motifs à ajouter/retrancher des motifs intitiaux, soit par convolution de la dose rayonnée avec le motif à graver soit en utilisant une table de paramètres. Le calcul combiné de la modulation de dose à appliquer et de la taille des motifs nouveaux est effectué de manière à préserver la latitude en énergie du procédé selon un calcul dont un exemple est donné ci-dessous en commentaire à la figure 7.

La figure 7 illustre le procédé de resizing des géométries à graver selon une variante de l'invention.
La géométrie des motifs est modifiée dans au moins une dimension pour optimiser la latitude en énergie du procédé. Plus précisément, on calcule le déplacement 750 à effectuer selon cette dimension en recherchant l'intersection de la droite 740 (tangente à la courbe de dose reçue, 720, au point où la dose reçue est égale au seuil de sensibilité de la résine à 0,5) avec la droite 730 qui matérialise ledit seuil de sensibilité, puis en effectuant le déplacement vers le point d'intersection de cette dernière droite avec le profil de la dose rayonnée 710.
Le calcul combiné dose/motifs peut être itéré deux ou trois fois.
La modulation de la dose à appliquer sur les motifs peut également être calculée à partir d'une table de paramètres sans calcul de convolution, notamment lorsque la modulation n'est appliquée que sur les shots extérieurs aux motifs, les autres shots étant appliqués à la valeur normalisée du procédé, ou à une valeur inférieure de l'ordre de 30% à celle-ci.

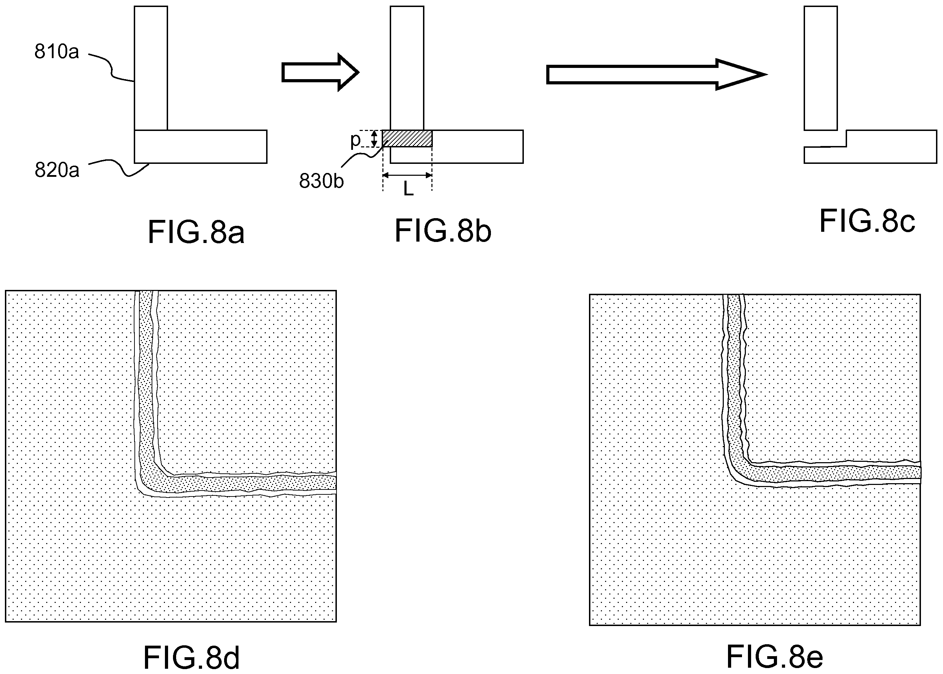

Les figures 8a, 8b, 8c, 8d et 8e illustrent l'application d'une technique d'extrusion utilisant une fonction de rescaling négatif dans un mode de réalisation de l'invention.
Selon un mode privilégié de réalisation de l'invention, pour un motif représenté sur la figure 8a, constitué de deux perpendiculaires, 810a, 820a, un motif de correction constitué par une extrusion, 830b, est créé dans au moins un des motifs perpendiculaires, 820a, à graver.
Les dimensions de l'extrusion p, L, sont déterminées dans l'étape de génération du motif de correction. L'extrusion peut par exemple être réalisée à l'aide de fonctions présentes dans la bibliothèque de l'outil. On génère d'abord un motif d'extension de la ligne 810a de largeur L et de hauteur p. Puis, à l'aide d'une fonction booléenne minus() entre 820a et 830b, on génère l'extrusion
Une fonction de rescaling négatif (par exemple, Inscale minus()) dans la bibliothèque de fonctions de l'outil
Le design qui sera projeté est représenté sur la figure 8c.
On note sur les figures 8d et 8e la différence sur le CD : dans le cas où la projection du motif original est effectuée sans correction, le CD est élargi au coin des deux motifs perpendiculaires (figure 8d); dans le cas où l'on applique la correction par extrusion selon le procédé de l'invention, dans un de ses modes de réalisation, le CD est constant tout au long de la ligne gravée.

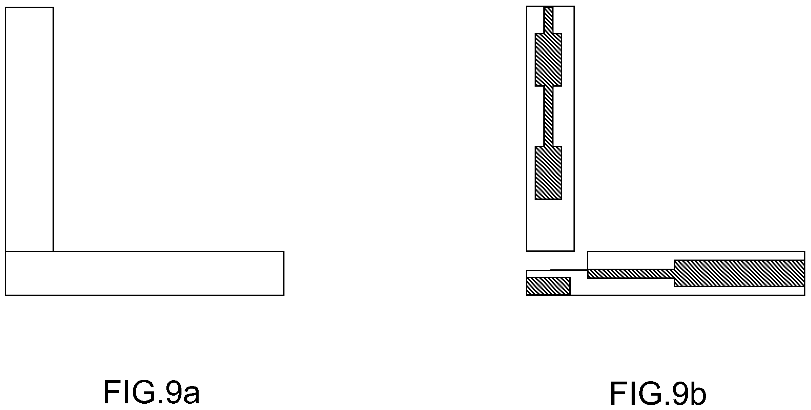

Les figures 9a et 9b illustrent l'application d'une technique de génération des motifs de correction utilisant une fonction eRIF dans un mode de réalisation de l'invention.
Un eRIF (pour electron Resolution Improvement Feature) est un motif additionnel de dimension inférieure au motif à imprimer qui permet d'améliorer la résolution ou la latitude de procédé. Sa taille et sa position peut être ajustée dans ce but. Pour les outils d'insolation qui permettent l'exposition multiple, ils sont en général placés en superposition du motif original. Sur la figure 9b, on combine l'extrusion décrite ci-avant avec une fonction eRIF.

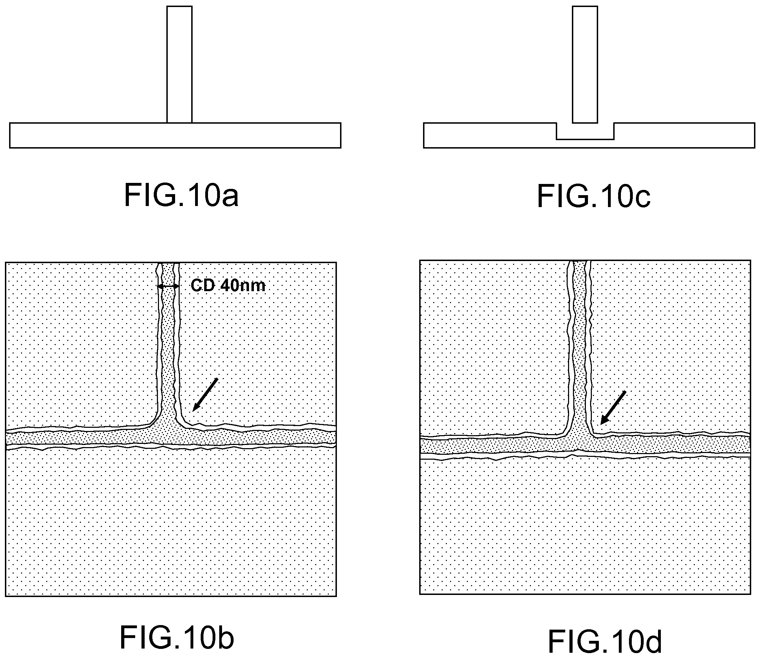

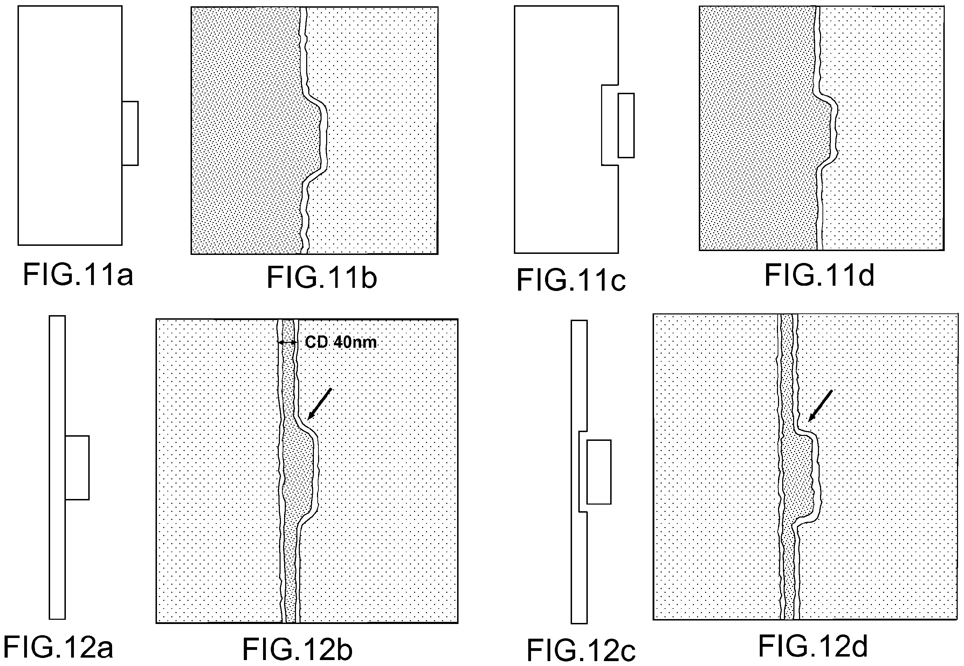

Les figures 10a à 16d illustrent plusieurs exemples de réalisation de l'invention d'une technique d'extrusion d'un motif de correction par comparaison avec une réalisation de l'exposition sans extrusion, pour plusieurs types particuliers de motifs à graver ;
Les figures indexées en a illustrent le motif à graver. Les figures indexées en b illustrent le résultat d'une gravure de ce motif sans application des corrections selon l'invention. Les figures indexées en c illustrent le motif effectivement projeté après application de l'extrusion selon l'invention. Les figures indexées en d illustrent le résultat de la gravure du motif corrigé par l'extrusion selon le procédé de l'invention.

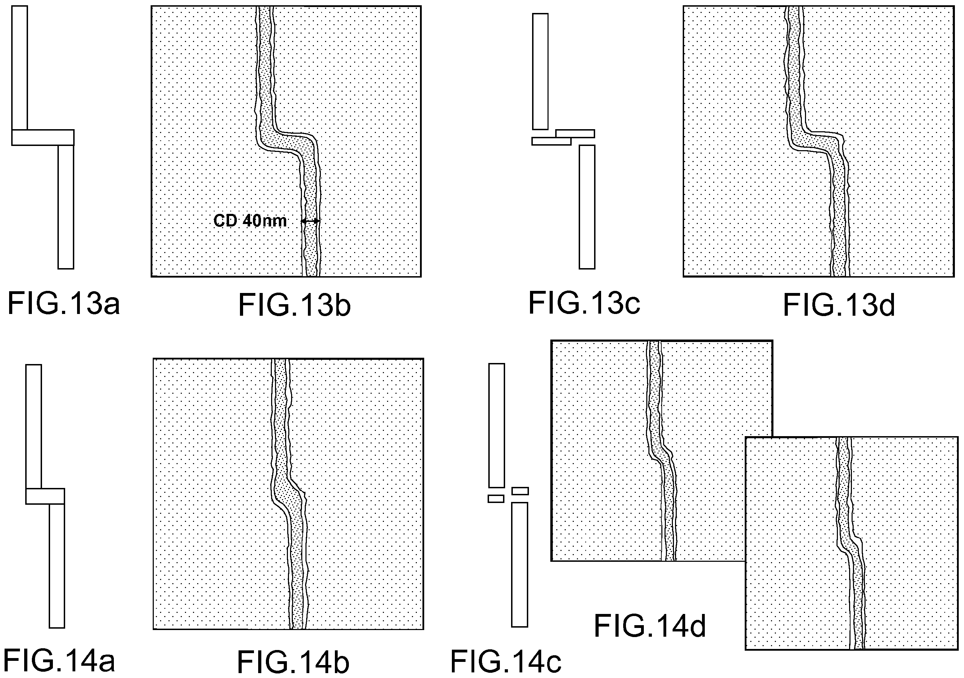

Les différents cas se distinguent par la taille respective des motifs perpendiculaires, leurs géométries, qui peuvent comporter plus de deux segments, comme dans les cas des figures 13a à d et 14a à 14d, la réalisation d'extrusions discontinues (deux dans le cas de la figure 13c), la géométrie des extrusions réalisées, qui peut être complexe, comme dans le cas de la figure 14c.

Dans tous les cas, la fracturation réalisée n'est pas modifiée, ce qui constitue un avantage de l'invention.

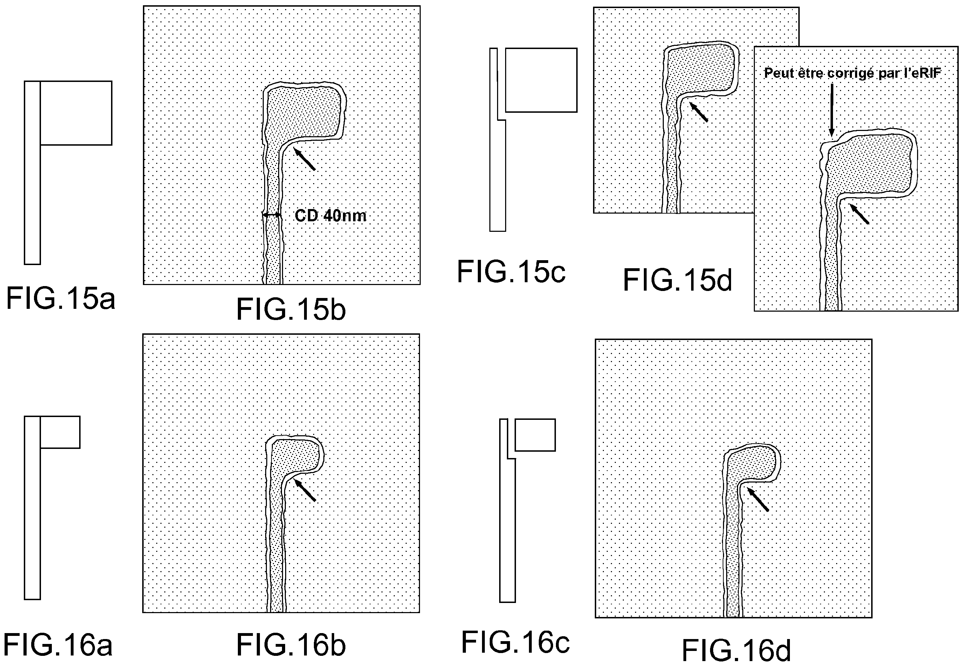

On voit également en comparant les deux photos de la figure 15d que le coin rentrant présente un arrondi bien plus faible. Les imperfections qui demeurent, tel le coin supérieur gauche du motif peuvent être corrigées par application d'une fonction eRIF

La méthode de l'invention a été décrite dans un exemple d'application à un procédé de lithographie électronique par écriture directe. Elle peut également être appliquée à un autre procédé de lithographie électronique utilisant des masques.
Les exemples décrits ci-dessus sont donc donnés à titre d'illustration de certains de modes de réalisation de l'invention. L'invention est définie par les revendications qui suivent.

## Revendications

1. Procédé de lithographie électronique de réseaux de motifs sur un substrat résiné comprenant au moins deux motifs perpendiculaires (510a, 520a, 810a, 820a) positionnés de manière contiguë, ledit procédé comprenant une étape de détermination desdits motifs contigus, une étape de génération d'au moins un motif de correction (530b, 830b), ledit motif comprenant au moins une zone de non exposition de la résine qui sépare lesdits deux motifs contigus et une étape de combinaison dudit motif de correction avec lesdits motifs contigus, ledit procédé étant **caractérisé en ce que** lesdits au moins deux motifs contigus ne sont plus contigus après ladite étape de combinaison.

2. Procédé de lithographie selon la revendication 1, **caractérisé en ce que** la dimension critique du réseau de motifs est de l'ordre de 35 nm et ladite zone de non exposition de la résine produit un espacement entre lesdits deux motifs contigus de l'ordre de 10 nm.

3. Procédé de lithographie selon la revendication 1, **caractérisé en ce que** ledit motif de correction détermine une zone d'exposition de la résine ajoutée de manière contigüe à l'un au moins desdits deux motifs contigus.

4. Procédé de lithographie selon la revendication 3, **caractérisé en ce que** la dimension critique du réseau de motifs est de l'ordre de 35 nm, et ladite zone d'exposition de la résine produit un allongement dudit au moins un des deux motifs contigus dans sa plus grande dimension de l'ordre de 5 nm.

5. Procédé de lithographie selon l'une quelconque des revendications 1 à 4, **caractérisé en ce que** lesdits motifs de correction, leurs dimensions et leurs emplacements sont déterminés par un modèle de détermination automatique d'un design cible comprenant les motifs contigus et les motifs de correction.

6. Procédé de lithographie selon l'une quelconque des revendications 1 à 5, **caractérisé en ce qu'**il comprend en outre au moins une étape de calcul d'au moins une dimension d'au moins un des motifs contigus et une étape de calcul de modulation de doses sur lesdits motifs, lesdits calculs étant liés par une relation fonctionnelle faisant intervenir la latitude en énergie du procédé.

7. Procédé de lithographie selon l'une quelconque des revendications 1 à 6, **caractérisé en ce que** l'étape de combinaison dudit motif de correction avec lesdits motifs contigus utilise une fonction de rescaling négatif de la zone de non exposition.

8. Procédé de lithographie selon l'une quelconque des revendications 1 à 7, **caractérisé en ce que** l'étape de génération d'au moins un motif de correction utilise un motif additionnel de dimension inférieure au motif à imprimer qui permet d'améliorer la résolution ou la latitude de procédé.

9. Programme d'ordinateur comprenant des instructions de code de programme permettant l'exécution du procédé de lithographie électronique de réseaux de motifs sur un substrat résiné comprenant au moins deux motifs perpendiculaires positionnés de manière contiguë selon l'une des revendications 1 à 8 lorsque le programme est exécuté sur un ordinateur, ledit programme d'ordinateur comprenant un module de détermination desdits motifs contigus, un module de génération d'au moins un motif de correction, comprenant au moins une zone de non exposition de la résine qui sépare lesdits deux motifs contigus et un module de combinaison dudit motif de correction avec lesdits motifs contigus, ledit programme d'ordinateur étant **caractérisé en ce que** lesdits au moins deux motifs contigus ne sont plus contigus après ladite étape de combinaison.

10. Programme d'ordinateur selon la revendication 9, caractérisé qu'il comprend en outre un module d'application d'un modèle de détermination automatique d'un design cible comprenant les motifs contigus et les motifs de correction dont les dimensions et les emplacements sont déterminés par ledit modèle.

11. Programme d'ordinateur selon l'une quelconque des revendications 9 à 10, **caractérisé en ce qu'**il comprend en outre au moins un module de calcul d'au moins une dimension d'au moins un des motifs contigus et un module de calcul de modulation de doses sur lesdits motifs, lesdits calculs étant liés par une relation fonctionnelle faisant intervenir la latitude en énergie du procédé.

## Patentansprüche

1. Elektronisches Lithografieverfahren für Motivanordnungen auf einem mit Harz behandelten Substrat umfassend mindestens zwei senkrechte Motive (510a, 520a, 810a, 820a), die anliegend positioniert sind, wobei das Verfahren einen Bestimmungsschritt der anliegenden Motive, einen Erzeugungsschritt von mindestens einem Korrekturmotiv (530b, 830b) umfasst, das Motiv umfassend mindestens eine Nichtaussetzungszone des Harzes, die die zwei anliegenden Motive trennt, und einen Kombinationsschritt des Korrekturmotivs mit den anliegenden Motiven, wobei das Verfahren **dadurch gekennzeichnet ist, dass** die mindestens zwei anliegenden Motive nach dem Kombinationsschritt nicht mehr anliegend sind.

2. Lithografieverfahren nach Anspruch 1, **dadurch gekennzeichnet, dass** die kritische Abmessung der Motivanordnung in der Größenordnung von 35 nm liegt und die Nichtaussetzungszone des Harzes einen Abstand zwischen den zwei anliegenden Motiven in der Größenordnung von 10 nm erzeugt.

3. Lithografieverfahren nach Anspruch 1, **dadurch gekennzeichnet, dass** das Korrekturmotiv eine Aussetzungszone des Harzes bestimmt, die anliegend an mindestens eines der zwei anliegenden Motive hinzugefügt wird.

4. Lithografieverfahren nach Anspruch 3, **dadurch gekennzeichnet, dass** die kritische Abmessung der Motivanordnung in der Größenordnung von 35 nm liegt und die Aussetzungszone des Harzes eine Streckung des mindestens einen der zwei anliegenden Motive in seiner größten Abmessung in der Größenordnung von 5 nm erzeugt.

5. Lithografieverfahren nach einem der Ansprüche 1 bis 4, **dadurch gekennzeichnet, dass** die Korrekturmotive, ihre Abmessungen und ihre Stellen durch ein automatisches Bestimmungsmodul eines Zieldesigns umfassend die anliegenden Motive und die Korrekturmotive bestimmt werden.

6. Lithografieverfahren nach einem der Ansprüche 1 bis 5, **dadurch gekennzeichnet, dass** es ferner mindestens einen Berechnungsschritt von mindestens einer Abmessung von mindestens einem der anliegenden Motive und einen Berechnungsschritt einer Dosismodulation über die Motive umfasst, wobei die Berechnungen durch eine funktionelle Beziehung verbunden sind, an der der Energiespielraum des Verfahrens beteiligt ist.

7. Lithografieverfahren nach einem der Ansprüche 1 bis 6, **dadurch gekennzeichnet, dass** der Kombinationsschritt des Korrekturmotivs mit den anliegenden Motiven eine negative Umskalierungsfunktion der Nichtaussetzungszone verwendet.

8. Lithografieverfahren nach einem der Ansprüche 1 bis 7, **dadurch gekennzeichnet, dass** der Erzeugungsschritt von mindestens einem Korrekturmotiv ein zusätzliches Motiv mit einer kleineren Abmessung als das zu druckende Motiv verwendet, das es ermöglicht, die Auflösung oder den Spielraum des Verfahrens zu verbessern.

9. Computerprogramm umfassend Programmcodeanweisungen, die die Ausführung des elektronischen Lithografieverfahrens für Motivanordnungen auf einem mit Harz behandelten Substrat umfassend mindestens zwei senkrecht anliegend positionierte Motive nach einem der Ansprüche 1 bis 8 ermöglichen, wenn das Programm auf einem Computer ausgeführt wird, das Computerprogramm umfassend ein Bestimmungsmodul der anliegenden Motive, ein Erzeugungsmodul von mindestens einem Korrekturmotiv, umfassend mindestens eine Nichtaussetzungszone des Harzes, die die zwei anliegenden Motive trennt, und ein Kombinationsmodul des Korrekturmotivs mit den anliegenden Motiven, wobei das Computerprogramm **dadurch gekennzeichnet ist, dass** die mindestens zwei anliegenden Motive nach dem Kombinationsschritt nicht mehr anliegend sind.

10. Computerprogramm nach Anspruch 9, **dadurch gekennzeichnet, dass** es ferner ein Anwendungsmodul eines automatischen Bestimmungsmodells eines Zieldesigns umfasst, umfassend die anliegenden Motive und die Korrekturmotive, deren Abmessungen und Positionen durch das Modell bestimmt werden.

11. Computerprogramm nach einem der Ansprüche 9 bis 10, **dadurch gekennzeichnet, dass** es ferner mindestens ein Berechnungsmodul von mindestens einer Abmessung von mindestens einem der anliegenden Motive und ein Berechnungsmodul für eine Dosierungsmodulation über die Motive umfasst, wobei die Berechnungen durch eine funktionelle Beziehung verbunden sind, an der der Energiespielraum des Verfahrens beteiligt ist.

## Claims

1. Electron-beam lithography method for networks of patterns on a resin-coated substrate comprising at least two perpendicular patterns (510a, 520a, 810a, 820a) which are positioned in a contiguous manner, the method comprising a step of determining the contiguous patterns, a step of generating at least one correction pattern (530b, 830b), the pattern comprising at least one non-exposure zone of the resin which separates the two contiguous patterns,
and a step of combining the correction pattern with the contiguous patterns, the method being **characterised in that** the at least two contiguous patterns are no longer contiguous after the combination step.

2. Lithography method according to claim 1, **characterised in that** the critical dimension of the network of patterns is in the order of 35 nm and the non-exposure zone of the resin produces a spacing between the two contiguous patterns in the order of 10 nm.

3. Lithography method according to claim 1, **characterised in that** the correction pattern determines an exposure zone of the resin which is added in a contiguous manner to at least one of the contiguous patterns.

4. Lithography method according to claim 3, **characterised in that** the critical dimension of the network of patterns is in the order of 35 nm, and the exposure zone of the resin produces an extension of the at least one of the two contiguous patterns in the largest dimension thereof in the order of 5 nm.

5. Lithography method according to any one of claims 1 to 4, **characterised in that** the correction patterns, their dimensions and their locations are determined by a model for automatically determining a target design comprising the contiguous patterns and the correction patterns.

6. Lithography method according to any one of claims 1 to 5, **characterised in that** it further comprises at least one step of calculating at least one dimension of at least one of the contiguous patterns and a step of calculating the modulation of doses on the patterns, the calculations being linked by means of a functional relationship which involves the energy latitude of the process.

7. Lithography method according to any one of claims 1 to 6, **characterised in that** the step of combining the correction pattern with the contiguous patterns uses a negative rescaling function of the non-exposure zone.

8. Lithography method according to any one of claims 1 to 7, **characterised in that** the step of generating at least one correction pattern uses an additional pattern having a dimension which is less than the pattern which is intended to be printed, which enables the resolution or the process latitude to be improved.

9. Computer programme comprising programme encoding instructions which enable the execution of the electron-beam lithography method of networks of patterns on a resin-coated substrate comprising at least two perpendicular patterns which are positioned in a contiguous manner according to any one of claims 1 to 8 when the programme is carried out on a computer, the computer programme comprising a module for determining the contiguous patterns, a module for generating at least one correction pattern, comprising at least one non-exposure zone of the resin which separates the two contiguous patterns and a module for combining the correction pattern with the contiguous patterns, the computer programme being **characterised in that** the at least two contiguous patterns are no longer contiguous after the combination step.

10. Computer programme according to claim 9, **characterised in that** it further comprises a module for applying a model for automatically determining a target design which comprises the contiguous patterns and the correction patterns whose dimensions and locations are determined by the model.

11. Computer programme according to any one of claims 9 to 10, **characterised in that** it further comprises at least one module for calculating at least one dimension of at least one of the contiguous patterns, and a module for calculating the modulation of doses on the patterns, the calculations being linked by a functional relationship which involves the energy latitude of the process.
